(19) Europäisches Patentamt
European Patent Office
Office européen des brevets

(11) **EP 3 343 624 B1**

(12) **EUROPEAN PATENT SPECIFICATION**

(45) Date of publication and mention
of the grant of the patent:
**02.09.2020   Bulletin 2020/36**

(51) Int Cl.:
***H01L 27/32*** *(2006.01)*

(21) Application number: **17180533.6**

(22) Date of filing: **10.07.2017**

(54) **ELECTRO-LUMINESCENCE DISPLAY APPARATUS AND MANUFACTURING METHOD THEREOF**

ELEKTROLUMINESZENTE ANZEIGEVORRICHTUNG UND HERSTELLUNGSVERFAHREN DAFÜR

AFFICHEUR ÉLECTROLUMINESCENT ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.12.2016   KR 20160182953**

(43) Date of publication of application:
**04.07.2018   Bulletin 2018/27**

(73) Proprietor: **LG Display Co., Ltd.**
**Seoul 07336 (KR)**

(72) Inventors:
• **KIM, JungChul**
**10845 Gyeonggi-do (KR)**
• **KWON, JunYoung**
**10845 Gyeonggi-do (KR)**

(74) Representative: **Ter Meer Steinmeister & Partner**
**Patentanwälte mbB**
**Nymphenburger Straße 4**
**80335 München (DE)**

(56) References cited:
**US-A1- 2007 085 847     US-A1- 2012 282 741**
**US-A1- 2014 361 290**

**Description**

**BACKGROUND**

**Technical Field**

The present disclosure relates to an active matrix type electro-luminescence display device and manufacturing method thereof.

**Related Technology**

An electro-luminescence element, which is a self-emissive element includes an anode electrode, a cathode electrode and an electro-luminescence layer formed there between. The electro-luminescence layer comprises a hole transport layer (HTL), an emission layer (EML), and an electron transport layer (ETL). When voltages are applied to the anode electrode and the cathode electrode, an exciton is generated by combining a hole passed through the hole transport layer (HTL) and an electron passed through the electron transport layer (ETL), whereby a visible light is emitted at the emission layer (EML). The active matrix type electro-luminescence display device including a self-emissive electro-luminescence element is advantageous in terms of fast response speed, emission efficiency, brightness and wide viewing angle characteristics. For these reasons, the electro-luminescence display device is being widely used.

A plurality of pixels (P) of the electro-luminescence display device arranged in a matrix comprising an electro-luminescence diode (ELD), respectively, which controls the brightness of the plurality of pixels according to the gray level of the video data. Each pixel includes a driving transistor which controls a driving current supplied to the electro-luminescence diode according to the potential difference between the gate electrode and the source electrode of the driving transistor and at least one switch transistor which programs the potential difference between the gate electrode and the source electrode of the driving transistor. The driving current is determined according to the potential difference between the gate electrode and the source electrode of the driving transistor and the threshold voltage of the driving transistor. The brightness of the pixel is proportional to the amount of the driving current supplied the electro-luminescence diode.

Accordingly, the potential difference between gate and the source electrode of the driving transistor should be maintained in an accurate and secure manner for displaying the pixel with a desired brightness value. However, for various reasons, there may be unwanted deviations with respect to voltages at each electrode.

For example, threshold voltage ($V_{th}$) deviation of the transistor may exist. Further, gate lines, emission lines and data lines may generate parasitic capacitance with any neighboring electrodes. As a result, when gate signals, emission signals and data signals are changed, a kickback voltage may be generated at the neighboring electrodes. At that time, the kickback voltage may be generated in an uneven manner according to the positional relationship with respect to the neighboring electrodes where the kickback voltage is generated.

Conventionally, there are attempts to compensate such threshold voltage deviation ($\Delta V_{th}$) by implementing internal compensation circuit or external compensation circuit techniques.

US 2007/085847 A1 describes a display device and a driving method thereof, where variations in the threshold voltage of transistors can be compensated and thus variations in luminance of light-emitting elements can be suppressed. In a first period, initialization is performed; in a second period, a voltage based on the threshold voltage of a first transistor is held in first and second storage capacitors; in a third period, a voltage based on a video signal voltage and the threshold voltage of the first transistor is held in the first and second storage capacitors; and in a fourth period, voltages held in the first and second storage capacitors are applied to a gate terminal of the first transistor to supply a current to a light-emitting element, so that the light-emitting element emits light.

US 2014/361290 A1 describes a pixel including a selection transistor, a driver transistor, and a light-emitting element. As the driver transistor, a transistor is used in which a channel is formed in an oxide semiconductor film and its channel length is 0.5 $\mu$m or greater and 4.5 $\mu$m or less. The driver transistor includes a first gate electrode over an oxide semiconductor film and a second gate electrode below the oxide semiconductor film. The first gate electrode and the second gate electrode are electrically connected to each other and overlap with the oxide semiconductor film.

US 2012/282741 A1 describes a method of manufacturing a thin film transistor device that includes the following steps: forming slanted portions in edges of crystalline semiconductor films; forming a resist film on the crystalline semiconductor film so as to expose the slanted portions and so as to cover the entire crystalline semiconductor film; performing half exposure of the resist film that is formed on the crystalline semiconductor film; injecting a p-type impurity only into the slanted portions of the crystalline semiconductor film; removing the resist film that is formed on the crystalline semiconductor film by ashing; and injecting the p-type impurity into the entire crystalline semiconductor film.

## SUMMARY

The inventor of the present disclosure researched a structure and manufacturing method for an electro-luminescence display device, which is capable of providing a superior image quality.

In particular, the inventor of the present disclosure recognized that deviations in taper angles of the channel areas of the plurality of transistors of the pixels of the electro-luminescence display device affect the image quality of electro-luminescence display device. Further, it is recognized that the taper angle tends to vary according to the size of the channel area of transistors. In other words, it is discovered that as the size of the channel area becomes smaller, the angle of the taper becomes larger. Also it is discovered that as the size difference between the channel areas becomes larger, the taper angle deviation becomes larger.

Further, the inventor of the present disclosure recognized that a threshold voltage deviation of a transistor tends to increase as the taper angle deviation becomes larger. Consequently, a kickback voltage of a pixel becomes larger, whereby an image retention problem may be occurred.

Furthermore, the inventor of the present disclosure recognized that compensation performance of the conventional compensation circuits can be degraded when a threshold voltage deviation between a driving transistor and a switching transistor is in presence.

Accordingly, an object of the present disclosure is to provide an electro-luminescence display device including a pixel which includes a driving transistor and a switching transistor with different channel area sizes with reduced taper angle deviation.

It should be noted that objects of the present disclosure are not limited to the above-described objects and other objects of the present disclosure will be apparent to those skilled in the art from the following descriptions.

The object is solved by the features of the independent claims. Preferred embodiments are given in the dependent claims.

To solve the above described problems, there is provided an electro-luminescence display device comprising: a pixel comprising: an electro-luminescence diode; a driving transistor configured to supply a current to the electro-luminescence diode; and a switching transistor configured to switch a signal supplied to the driving transistor, wherein an area of a channel region of the driving transistor is different from an area of a channel region of the switching transistor, and wherein the channel region of the driving transistor and the switching transistor includes each a semiconductor layer (ACT) having edges with a taper angle, and wherein a taper angle deviation between the taper angle of the semiconductor layer of the driving transistor and the taper angle of the semiconductor layer of the switching transistor is equal to or less than 10°. The taper angle deviation may be adjusted according to an $O_2$ gas flow rate during a dry etching process. The taper angle deviation may be equal to or less than 5°. The semiconductor layers of the driving transistor and the switching transistor may be dry etched with the $O_2$ gas flow rate equal to or more than 40%. The taper angle deviation may be equal to or less than 1°. The semiconductor layers of the driving transistor and the switching transistor may be dry etched with the O2 gas flow rate equal to or more than 50%. A taper angle of the semiconductor layer of the driving transistor and a taper angle of the semiconductor layer of the switch transistor may be respectively equal to or less than 20°. The taper angle of the semiconductor layer of the driving transistor and the taper angle of the semiconductor layer of the switch transistor may be respectively equal to or less than 10°. The taper angle deviation may be equal to or less than 5°. The area of the channel region of the driving transistor may be larger than the area of the channel region of the switching transistor. A semiconductor layer, configuring the driving transistor and the switching transistor, includes a low-temperature poly silicon layer.

To solve the above described problems, there is provided a manufacturing method of an electro-luminescence display device as described in claim 12.

The semiconductor layer may be a low-temperature poly silicon layer which may be crystalized by a laser. The predetermined degree may be equal to or less than 20°. The predetermined degree may be equal to or less than 10° and the $O_2$ gas flow rate may be equal to or more than 50%. A mixture gas used for the dry etching process includes the $O_2$ gas and at least one gas among $CF_4$, $SF_6$, He, HCl and $Cl_2$.

More details of the embodiments of the present disclosure are disclosed in the detailed description and the appended drawings.

According to the embodiments of the present disclosure, it is advantageous that respective taper angle of the transistors of a plurality of pixels is formed to be equal to or less than a specific degree, whereby brightness uniformity and image sticking recovery characteristics can be improved.

According to the embodiments of the present disclosure, it is advantageous that the transistors of the electro-luminescence display device are formed such that a taper angle deviation values with respect to the channel areas of the transistors to be equal to or less than a specific value, whereby threshold voltage deviation with respect to the transistors having different sizes of channel areas can be reduced.

It should be noted that the effects of the present disclosure are not limited to those described above and other effects of the present disclosure are included in the following descriptions.

## BRIEF DESCRIPTION OF THE DRAWINGS

The above and other aspects, features and other advantages of the present disclosure will be more clearly understood from the following detailed description taken in conjunction with the accompanying drawings, in which:

FIG. 1 is a conceptual diagram schematically illustrating an electro-luminescence display device according to an embodiment of the present disclosure;
FIG. 2 is an equivalent circuit diagram schematically illustrating a pixel of the display panel of FIG. 1;
FIG. 3 is a schematic waveform graph illustrating scan signals for driving the pixel and corresponding node voltages of the pixel;
FIG. 4A is an equivalent circuit diagram with respect to the pixel during an initialization period;
FIG. 4B is an equivalent circuit diagram with respect to the pixel during a sampling period;
FIG. 4C is an equivalent circuit diagram with respect to the pixel during an emission period;
FIG. 5 is a schematic circuit diagram illustrating parasitic capacitances generated by a gate electrode and another electrode (or a signal line) of a driving transistor at a transition time of the sampling period and the emission period;
FIG. 6A is a plan view schematically illustrating a driving transistor DT of the pixel of an electro-luminescence display device according to an embodiment of the present disclosure;
FIG. 6B is a schematic cross-sectional view taken along line A-A' in FIG. 6A;
FIG. 7A is a plan view schematically illustrating a switching transistor of a pixel of an electro-luminescence display device according to an embodiment of the present disclosure; and
FIG. 7B is a schematic cross-sectional view taken along line B-B' in FIG. 7A.

## DETAILED DESCRIPTION OF THE PRESENT DISCLOSURE

Advantages and features of the present disclosure and methods for accomplishing the same will be more clearly understood from exemplary embodiments described below with reference to the accompanying drawings. However, the present disclosure is not limited to the following exemplary embodiments but may be implemented in various different forms. The exemplary embodiments are provided only to complete disclosure of the present disclosure and to fully provide a person having ordinary skill in the art to which the present disclosure pertains with the category of the invention and the present invention will be defined by the appended claims.

The shapes, sizes, ratios, angles, numbers and the like illustrated in the accompanying drawings for describing the exemplary embodiments of the present disclosure are merely examples and the present disclosure is not limited thereto. Like reference numerals generally denote like elements throughout the present specification. Further, in the following description, a detailed explanation of known related technologies may be omitted to avoid unnecessarily obscuring the subject matter of the present disclosure. The terms such as "including", "having", "comprising" and "consist of" used herein are generally intended to allow other components to be added unless the terms are used with the term "only". Any references to singular may include plural unless expressly stated otherwise.

Components are interpreted to include an ordinary error range or an ordinary tolerance range even if not expressly stated.

When the position relation between two parts is described using the terms such as "on", "above", "below" and "next", on or more parts may be positioned between the two parts unless the terms are used with the term "immediately" or "directly".

When an element or layer is referred to as being "on" another element or layer, it may be directly on the other element or layer, or intervening elements or layers may be present.

Although the terms "first", "second" and the like are used for describing various components, these components are not confined by these terms. These terms are merely used for distinguishing one component from the other components. Therefore, a first component to be mentioned below may be a second component in a technical concept of the present disclosure.

Throughout the whole specification, the same reference numerals denote the same elements.

Since size and thickness of each component illustrated in the drawings are represented for convenience in explanation, the present disclosure is not necessarily limited to the illustrated size and thickness of each component.

The features of various embodiments of the present disclosure can be partially or entirely bonded to or combined with each other and can be interlocked and operated in technically various ways as can be fully understood by a person having ordinary skill in the art and the embodiments can be carried out independently of or in association with each other.

Various exemplary embodiments of the present disclosure will be described in detail with reference to the accompanying drawings.

Although the transistors of the embodiments of the present disclosure are illustrated as a P-type but the technical concept of the present disclosure is not limited thereto and the transistors can be realized as an N-type.

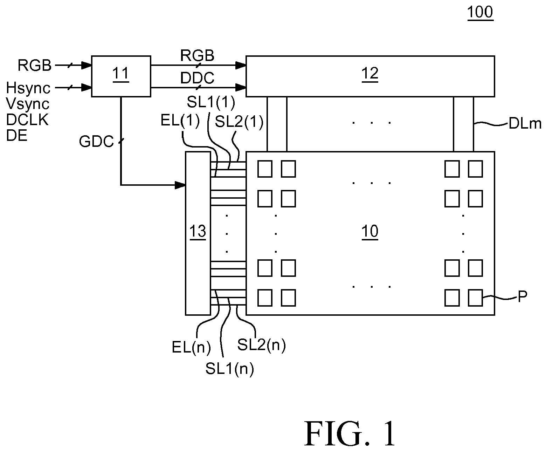

FIG. 1 is a conceptual diagram schematically illustrating an electro-luminescence display device 100 according to an embodiment of the present disclosure.

Referring to FIG. 1, an electro-luminescent display device 100 according to an exemplary embodiment of the present disclosure is described below.

An electro-luminescence display device 100 according to an embodiment of the present disclosure includes a display panel 10 in which a plurality of pixels P are formed thereon, a data driver 12 for driving a plurality of data lines (DL[1] ~ DL[m]), a gate driver 13 for driving a plurality of gate lines (EL[1] ~ EL(n), SL1[1] ~ SL1(n), SL2[1] ~ SL2(n)), a timing controller 11 for controlling the data driver 12 and the gate driver 13.

The plurality of pixels P at the display panel 10 is arranged so as to display an image. The pixels P at $n^{th}$ horizontal line are electrically connected to $n^{th}$ emission line EL, $n^{th}$ 1st scan line SL1 and $n^{th}$ 2st scan line SL2. The pixel P in each column is electrically connected to a corresponding data line DL, respectively.

The transistors TFT configuring the pixel P may be formed of polycrystalline silicon (poly-Si).

The plurality of pixels P in the pixel area is configured to receive a high potential voltage ELVDD, a low potential voltage ELVSS, and an initial voltage Vini from a power supply unit. The initialization voltage may be selected from a range which is sufficiently lower than the operating voltage of an electro-luminescence diode ELD, whereby unnecessary emission of an electro-luminescence diode ELD during an initialization period and a sampling period can be suppressed. That is, the initial voltage Vini may be set to be equal to or lower potential than the low potential voltage ELVSS. Accordingly, the initial voltage Vini which is lower than the low potential voltage ELVSS may be supplied, whereby the lifetime of the electro-luminescence diode ELD can be extended.

The timing controller 11 rearranges the digital video data RGB received from an external system so as to be compatible to the resolution of the display panel 10 then supply to the data driver 12. Further, the timing controller 11 generates signals such as a data control signal DDC for controlling the operating timing of the data driver 12 and a gate control signal GDC for controlling the operating timing of the gate driver 13, which are generated based on timing signals such as vertical synchronization signal Vsync, horizontal synchronization signal Hsync, dot clock signal DCLK, and data enable signal DE.

The data driver 12 converts the digital video data RGB received from the timing controller 11 into an analogue data voltages based on the data control signal DDC.

The gate driver 13 generates scan and emission signals based on the gate control signal GDC. The gate driver 13 may be configured to include a scan driver and an emission driver. The scan driver may supply a first scan signal SCAN1 to the first scan line SL1 and a second scan signal SCAN2 to the second scan line SL2, the emission driver may supply an emission signal EM to the emission line EL. Such gate driver 13 may be directly formed in the periphery area of the display panel 10 by a gate driver in panel GIP technique. But the present disclosure is not limited to those above described elements and are merely an exemplary embodiment of the present disclosure.

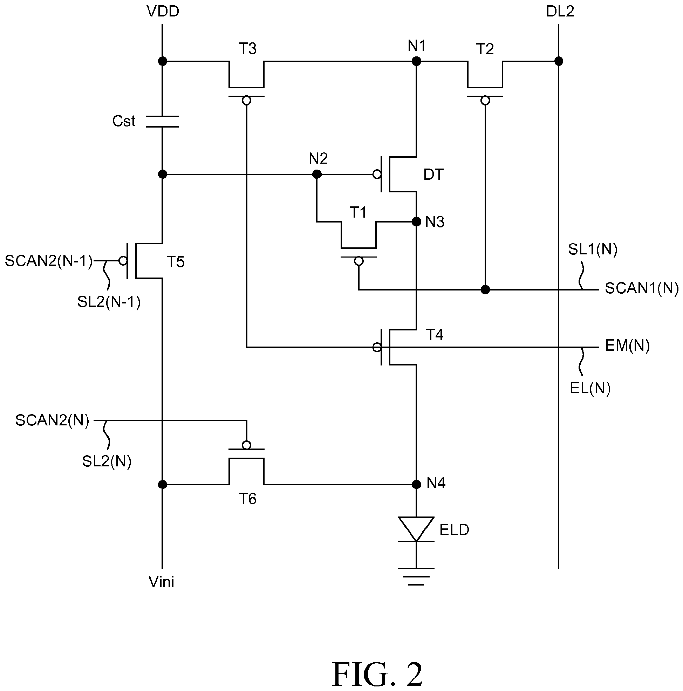

FIG. 2 is an equivalent circuit diagram schematically illustrating a pixel P of a display panel 10 of FIG. 1.

Referring to FIG. 2, the pixel P of the display panel 10 of the electro-luminescence display device 100 according to an exemplary embodiment of the present disclosure will be described below.

Each pixel P includes an electro-luminescence diode ELD, a driving transistor DT, first to sixth transistors (T1 ~ T6) and a capacitor Cst. But the present disclosure is not limited to those above described elements and are merely an exemplary embodiment of the present disclosure. The first to sixth transistors (T1 ~ T6) may be referred as switching transistors ST.

The electro-luminescence diode ELD is emitted by a driving current supplied from the driving transistor DT. The electro-luminescence diode ELD includes an anode electrode, a cathode electrode and functional layers formed there between.

The functional layers may include at least one layer among a hole transport layer, an electron transport layer and an emission layer EML.

The hole transport layer is a layer for injecting a hole or transporting a hole. For example, a hole injection layer HIL, a hole transport layer HTL, an electron blocking layer EBL and extra may be regarded as the hole transport layer.

The electron transport layer is a layer for injecting an electron or transporting an electron. For example, an electron transport layer ETL, an electron injection layer HIL, a hole blocking layer HBL and extra may be regarded as the electron transport layer.

The anode of the electro-luminescence diode ELD is connected to the fourth node N4 and the cathode of the electro-luminescence diode ELD is connected to an input unit of the low potential voltage ELVSS.

The driving transistor DT controls the driving current supplied to the electro-luminescence diode ELD according to the potential difference between the gate electrode and the source electrode thereof. With respect to the driving transistor DT, the source electrode thereof is connected to the first node N1, the gate electrode thereof is connected to the second node N2 and the drain electrode thereof is connected to the third node N3.

The first transistor T1 includes a source electrode connected to the third node N3, a drain electrode connected to the second node N2 and a gate electrode connected to $n^{th}$ first scan line SL1(n). In response to the $n^{th}$ first scan signal SCAN1 (n), the first transistor T1 configures a diode connection which electrically shorts the gate electrode and the source electrode of the driving transistor DT so as to act as a diode.

The second transistor T2 includes a source electrode connected to a data line DL, a drain electrode connected to the first node N1 and a gate electrode connected to the $n^{th}$ first scan line SL1[N1]. As a result, in response to the first scan signal SCAN1(n), the second transistor T2 supplies a data voltage Vdata from the data line DL1 to the first node N1.

The third transistor T3 includes a source electrode connected to a high potential line VDD, a drain electrode connected to the first node N1 and a gate electrode connected to the emission line EL. As a result, in response to the emission signal EM, the third transistor T3 supplies the high potential voltage ELVDD to the first node N1.

The fourth transistor T4 includes a source electrode connected to the third node N3, a drain electrode connected to the fourth node N4 and a gate electrode connected to the emission line EL. In response to the emission signal EM, the fourth transistor T4 provides a current path between the third node N3 and the fourth node N4.

The fifth transistor T5 includes a drain electrode connected to the second node N2, a source electrode connected to an input unit of the initial voltage Vini and a gate electrode connected to $(N-1)^{th}$ second scan line SL2(N-1). In response to the $(N-1)^{th}$ second scan signal SCAN2(N-1), the fifth transistor T5 supplies the initial voltage Vini to the second node N2.

The sixth transistor T6 includes a drain electrode connected to the fourth node N4, a source electrode connected to the input unit of the initial voltage Vini and a gate electrode connected to $n^{th}$ second scan line SL2(n). In response to the $n^{th}$ second scan signal SCAN2(n), the sixth transistor T6 supplies the initial voltage Vini to the fourth node N4.

The storage capacitor Cst includes a first electrode connected to the second node N2 and a second electrode connected to a high voltage line VDD. But the present disclosure is not limited to those above described elements and are merely an exemplary embodiment of the present disclosure.

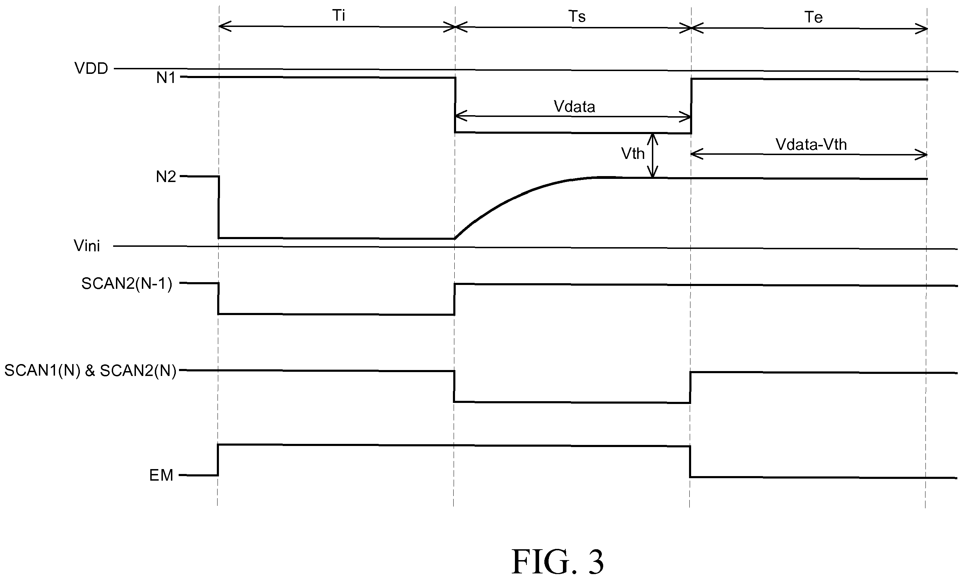

FIG. 3 is a schematic waveform graph illustrating scan signals for driving the pixel P and corresponding node voltages of the pixel P.

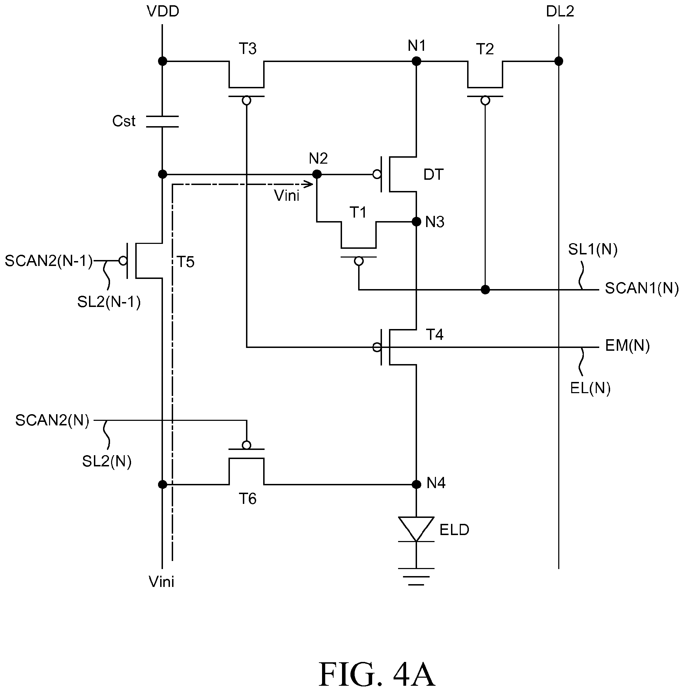

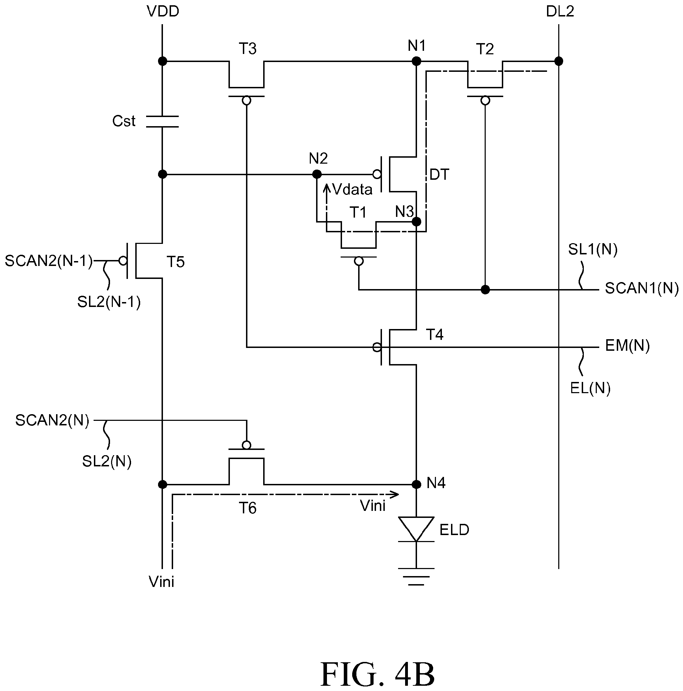

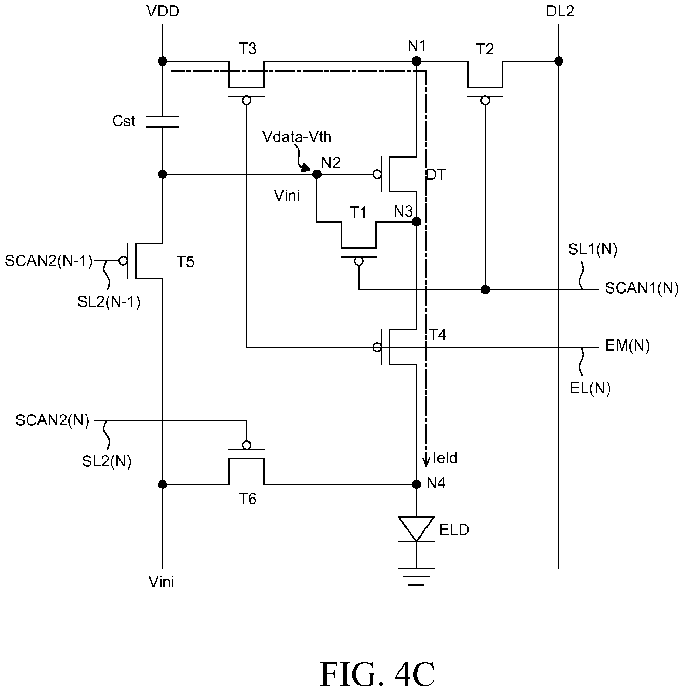

FIG. 4A is an equivalent circuit diagram with respect to the pixel P during an initialization period, FIG. 4B is an equivalent circuit diagram with respect to the pixel P during a sampling period and FIG. 4C is an equivalent circuit diagram with respect to the pixel during an emission period.

Referring to FIG. 2 to FIG. 4C, an operation of the electro-luminescence display device 100 according to an exemplary embodiment of the present disclosure will be described below.

An electro-luminescence display device 100 according to an exemplary embodiments of the present disclosure, a frame period may be divided into an initial period Ti, a sampling period Ts and an emission period Te. But the present disclosure is not limited thereto.

The initial period Ti is a period for initializing the gate electrode of the driving transistor. Sampling period Ts is a period for sampling the threshold voltage $V_{th}$ of the driving transistor DT and storing thereof to the second node N2 after the initialization of the voltage of the anode electrode of the electro-luminescence diode ELD. The emission period Te is a period for emitting the electro-luminescence diode ELD by the driving current determined by the programmed potential difference between the gate electrode and the source electrode of the driving transistor DT that including the sampled threshold voltage Vth.

The initial period Ti of the $n^{th}$ horizontal line overlaps with the sampling period Ts of the $(N-1)^{th}$ horizontal line. That is, according to the present disclosure, the sampling period Ts may be sufficiently secured, whereby compensation of the threshold voltage Vth can be more accurate. It should be noted that as the threshold voltage deviation ($\Delta V_{th}$) of the switching transistor ST and the driving transistor DT increases, compensation accuracy of the threshold voltage $V_{th}$ may be degraded.

During the initial period Ti, in response to the $n^{th}$ second scan signal SCAN2(n), the fifth transistor T5 applies the initial voltage Vini to the second node N2. Accordingly, the gate electrode of the driving transistor DT is initialized to the initial voltage Vini. The initial voltage Vini may be selected within a voltage range sufficiently lower than the operating voltage of the electro-luminescence diode ELD and can be set to a voltage equal to or lower than the low potential voltage ELVSS. During the initialization period Ti, the data voltage Vdata from the previous frame is maintained in the first node N1.

During the sampling period Ts, in response to the $n^{th}$ second scan signal SCAN2(n), the sixth transistor T6 supplies the initial voltage Vini to the fourth node N4. As a result, the anode electrode of the electro-luminescence diode ELD is initialized to the initializing voltage Vini.

In response to the $n^{th}$ first scan signal SCAN1(n), the second transistor T2 supplies the data voltage Vdata which is supplied from the data line DL1 to the first node N1. In response to the $n^{th}$ first scan signal SCAN1(n), the first transistor T1 is turned on so that the driving transistor DT becomes a diode connection status.

During the sampling period Ts, a current flows through the source electrode and the drain electrode of the driving transistor DT. As the gate electrode and the drain electrode of the driving transistor DT configures a diode connection, the voltage of the second node N2 gradually rises due to the current flowing from the source electrode to the drain electrode. During the sampling period Ts, the voltage of the second node N2 increases from the data voltage Vdata(n) up to a value (Vdata(n) - $V_{th}$) obtained by subtracting the threshold voltage $V_{th}$ of the driving transistor DT.

During the emission period Te, in response to the emission signal EM(n), the third transistor T3 supplies the high potential voltage VDD to the first node N1. In response to the nth emission signal EM(n), the fourth transistor T4 configures a current path between the third node N3 and the fourth node N4. Accordingly, the driving current $I_{eld}$ through the source electrode and the drain electrode of the driving transistor DT is supplied to the electro-luminescence diode ELD.

During the emission period Te, a relational expression for the driving current $I_{eld}$ flowing through the electro-luminescence diode ELD is represented by the following Equation 1.

[Equation 1]

$$I_{eld} = k/2(Vgs + |V_{th}|)^2 = k/2(Vg - Vs + |V_{th}|)^2 = k/2(Vdata - |V_{th}| - VDD + |V_{th}|)^2 = k/2(Vdata - VDD)^2$$

In Equation 1, k/2 represents a proportional constant determined by electron mobility, parasitic capacitance and width(W) and length(L) of the channel area of the driving transistor DT. The width of the channel region is determined according to the width (W) and the length (L) of the channel region.

According to the Equation 1, the threshold voltage $V_{th}$ component of the driving transistor DT is cancelled in the relational expression of the driving current $I_{eld}$. This means that the drive current $I_{eld}$ does not change with respect to the electro-luminescence display device according to the present disclosure.

That is, the data voltage of the electro-luminescence display device according to the present disclosure can be programmed regardless of the deviations in the threshold voltage $V_{th}$ during the sampling period Ts.

However, during the sampling period Ts, even if the potential difference between the gate electrode and the source electrode of the driving transistor DT is programmed to a desired voltage, the target luminance may not be accomplished if the gate electrode voltage of the driving transistor DT varies. The gate electrode of the driving transistor DT may form a parasitic capacitance with the adjacent electrode or signal lines, and the voltage at the second node N2 can be varied due to a kickback effect caused by the parasitic capacitance.

Change in voltage due to the parasitic capacitance at the second node N2 connected to the gate electrode of the driving transistor will now be described below.

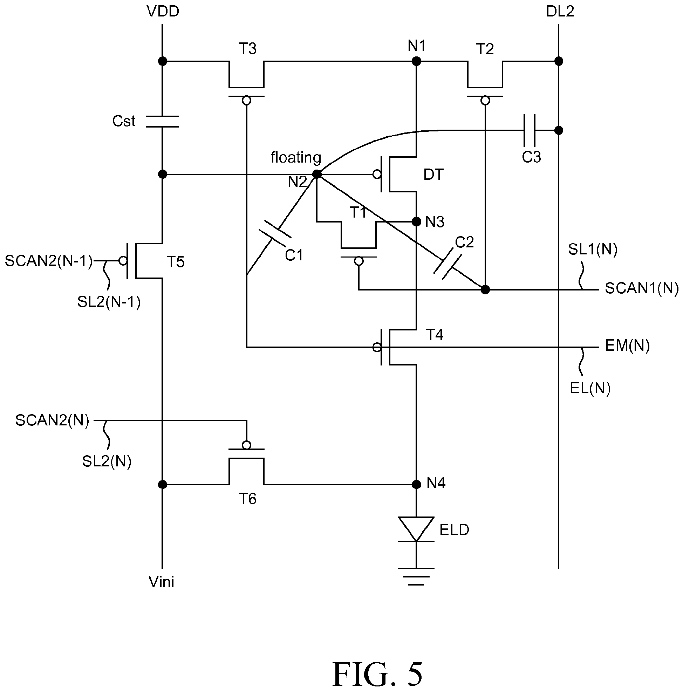

FIG. 5 is a schematic circuit diagram illustrating parasitic capacitances generated by a gate electrode and another electrode (or a signal line) of a driving transistor at a transition time of the sampling period and the emission period.

Referring to FIG. 5, the first parasitic capacitance C1 means a capacitance between the second node N2 and the emission line EL, the second parasitic capacitance C2 means a capacitance between the second node N2 and the first scan line SL1(N). The third parasitic capacitance C3 means a capacitance between the second node N2 and the data line DL.

As described in reference to FIG. 4B and FIG. 5, the second node N2 is programmed to a value of "Vdata-$V_{th}$" during the sampling period Ts and the value "Vdata-$V_{th}$" is maintained under the floating state during the emission period Te.

However, the voltage at the second node N2 under the floating state can be affected by the parasitic capacitance. Therefore, when the voltage of the adjacent signal lines changes at the start of the emission period Te, the voltage of the second node N2 also changes due to the kickback effect of each of the first to third parasitic capacitances C1 to C3. In particular, as the threshold voltage deviation ($\Delta V_{th}$) between the threshold voltage of the switching transistor ST and the threshold voltage of the driving transistor DT increases, the kickback voltage may increase.

Specifically, at the start of the emission period Te, the emission signal EM is inverted from a high potential voltage to a low potential voltage and the first scan signal SCAN1(N) is inverted from a low potential voltage to a high potential voltage. That is, as the voltage at the electrode, in which generating the parasitic capacitance with respect to the second node N2, may change, whereby the voltage of the second node N2 is changed by the kickback effect.

Hereinafter, the uniformity of the switching transistors ST (i.e., T1 to T6) of the pixel P according to the kickback voltage and the deviation in uniformity of the driving transistor DT will be described.

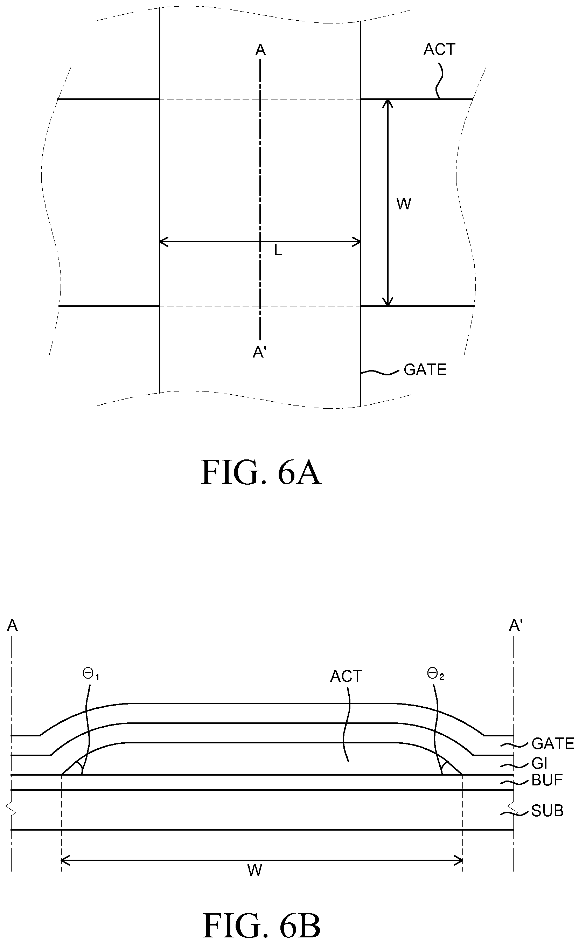

FIG. 6A is a plan view schematically illustrating a driving transistor DT of the pixel P of an electro-luminescence display device 100 according to an embodiment of the present disclosure. FIG. 6B is a schematic cross-sectional view taken along line A-A' in FIG. 6A

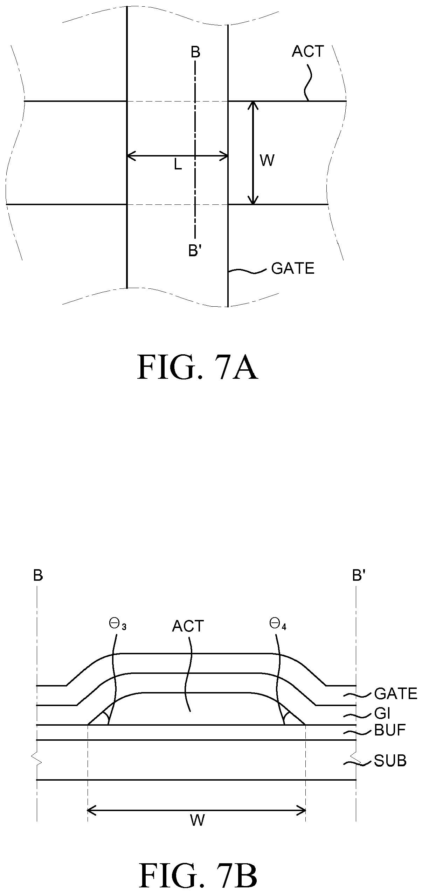

FIG. 7A is a plan view schematically illustrating a switching transistor ST of a pixel P of an electro-luminescence display device 100 according to an embodiment of the present disclosure. FIG. 7B is a schematic cross-sectional view taken along line B-B' in FIG. 7A.

Hereinafter, the present disclosure will be described in reference to Fig. 6A to FIG. 7B. A plurality of pixels P are formed on the substrate SUB. The substrate SUB may be made of glass or a flexible material. A buffer layer BUF is formed on the substrate SUB. The buffer layer BUF may be formed of silicon nitride (SiNx) and/or silicon oxide (SiOx), and may be formed as a single layer or a multilayer structure.

The semiconductor layer ACT of the transistors (DT, ST) of the pixel P according to an embodiment of the present disclosure is formed of the low temperature polysilicon (LTPS), which is crystalized by melting amorphous silicon (a-Si) by a laser. The crystallized semiconductor layer ACT is superior in current driving ability as compared with the case of the amorphous semiconductor layer. Therefore, the crystallized channel region can be relatively smaller as compared with the amorphous channel region, thereby a high-resolution display device can be realized. However, performance deviation may occur depending on the degree of crystallization of the channel region. That is, the crystallized semiconductor layer ACT has a difficulty in securing the uniformity of the channel region characteristics as compare with the amorphous semiconductor layer.

The semiconductor layer ACT may be deposited to a thickness of 300Å to 700Å, for example. A photo-resist is coated on the deposited semiconductor layer ACT. The photo-resist may be patterned by a photolithography process. After the photolithography process, the semiconductor layer ACT may be patterned by a dry-etching process. The dry etching process may be performed by selectively using a gas among $O_2$, $CF_4$, $SF_6$, He, HCl, $Cl_2$ and etc. $O_2$ gas is used to adjust the taper angle of the semiconductor layer ACT. The portion of the semiconductor layer ACT from which the photo-resist is removed is etched by a dry etching process to form a channel region and a line region of each transistor. After the dry etching process, the photo-resist can be removed by a stripping process.

The semiconductor layer ACT of the electro-luminescence display device 100 according to an exemplary embodiment of the present disclosure may be patterned using $CF_4$ gas and $O_2$ gas during the dry etching process as an example.

A gate insulating layer GI is disposed on the semiconductor layer ACT. The gate insulating layer GI may be made of silicon nitride (SiNx) and/or silicon oxide (SiOx), and may be formed as a single layer or a multilayer structure.

A gate electrode GATE is disposed on the gate insulating layer GI. The gate electrode GATE and the semiconductor layer ACT are electrically insulated by the gate insulating layer GI. The gate electrode GATE is made of a metallic material and may be formed of a metallic material having low resistance such as copper (Cu), aluminum (Al), molybdenum (Mo), and/or titanium (Ti). But the present disclosure is not limited thereto.

In addition, a region where the semiconductor layer ACT and the gate electrode GATE overlap each other in the respective transistors can be defined as a channel region. The region excluding the channel region in the semiconductor layer (ACT) can be defined as a line region. One side of the line region can be referred to as a source electrode with respect to the channel region and the other side can be referred to as a drain electrode. But the present disclosure is not limited thereto.

The line region of the semiconductor layer ACT may be referred to a metallized region formed by inserting impurities (i.e., dopant) into the semiconductor layer ACT. The channel region of the semiconductor layer ACT may be shielded from the impurities by using a mask. For example, the gate electrode GATE overlapping the channel region may function as a mask for blocking impurities. However, the present invention is not limited thereto, and it is also possible to design the region where impurity is doped by using a separate mask. The impurity supply process may be referred to as a doping process.

The line region of the semiconductor layer ACT may become conductive by a high concentration doping process. The impurity supplied to the line region of the semiconductor layer ACT may be doped with a Group 3 boron (B) which is an acceptor and/or a group 5 Phosphorus (P) which is a donor, although the present disclosure is not limited to the above-mentioned substances.

In addition, the channel region of the semiconductor layer ACT may be doped with a low concentration of acceptor, thereby the channel region may be of P-type. In this case, the transistor becomes a PMOS transistor. In addition, the channel region of the semiconductor layer ACT may be doped with a low concentration of donor, thereby the channel region may be formed of N-type. In this case, the transistor becomes an NMOS transistor.

As the line region of the semiconductor layer ACT of a predetermined transistor among the transistors of the pixel P has a metallic characteristic, the line region can be further extended so as to be a portion of a signal line and/or a node. That is, the line region, which is doped with a high concentration, interconnecting the channel regions of the different transistors in the pixel P may be realized as a connection line and/or a node. Further, a portion of the line region may be configured to be electrically connected to a metal signal line (e.g., a data line) connected through a contact hole passing through an insulating layer.

The width W and the length L of the semiconductor layer ACT of each of the transistors of the pixel P may be variously formed. The shape of the channel region of each of the transistors is not limited to a square shape, and may be realized in various shapes such as an "S" shape, an "L" shape, a "C" shape, and a curved shape. Further, the width W of the channel region may be differently formed depending on the specific position.

The performance of the transistor is determined by the length L and the width W of the channel region of the transistor. In order to supply sufficient current $I_{eld}$ by the driving transistor DT to the electro-luminescence diode ELD, the width W and the length L of the channel region should be sufficiently acquired.

Since the width W and the length L of the channel region of the switching transistor ST may be made relatively less than the channel region of the driving transistor DT. Accordingly, the channel region of the switching transistor ST may be configured to be relatively smaller than channel region of the driving transistor DT. That is, the area of the channel region of the driving transistor can be wider than the area of the channel region of the switching transistor.

It should be noted that if the dry etching process is performed without concerning the taper angle characteristics for different channel region areas of the transistors, whereby the respective taper angles of the semiconductor layer ACT may vary according to the different channel region areas of the transistors.

That is, in order to adjust the taper angles of the electro-luminescence display device 100, a step for providing a semiconductor layer ACT on a substrate SUB; a step for patterning a photo-resist on the semiconductor layer by a photolithography process; and a step for applying at least 30% of an $O_2$ gas flow rate for a dry etching process for patterning the taper angles of the channel regions of the driving transistor DT and the switching transistor ST having the semiconductor layer ACT, wherein the taper angles are formed to be equal to or less than a predetermined angle.

Referring to Table 1, present disclosure discloses that the taper angles of the semiconductor layer ACT of each transistor of the pixel P varies depending on the ratio of the gas applied in the dry etching process.

Specifically, when the semiconductor layer ACT is dry etched, the taper angle ($\theta$) of the edge of the semiconductor layer ACT can be adjusted by controlling the ratio of the $CF_4$ gas and the $O_2$ gas.

Referring to Table 1, $O_2$ means a contents of the $O_2$ gas among the $O_2$ gas and the $CF_4$ gas. ($\theta_1$) denotes a taper angle of one side of the channel region of the driving transistor DT. ($\theta_2$) denotes the taper angle of the other side of the channel region of the driving transistor DT. ($\theta_3$) denotes a taper angle of one side of the channel region of the switching transistor ST. ($\theta_4$) denotes the taper angle of the other side of the channel region of the switching transistor ST.

As an example, the width W of the channel region of the driving transistor DT is 5 $\mu$m and the length L is 20 $\mu$m. As an example, the width W of the channel region of the switching transistor ST is 3 $\mu$m and the length L is 3 $\mu$m. That is, the areas of the channel regions of the driving transistor DT and the switching transistor ST are different from each other.

Referring to Table 1, as the flow rate ratio of $O_2$ gas increases, the overall taper angles of the transistor having a different channel region area is reduced. That is, the taper angle of the semiconductor layer can be adjusted according to the ratio of the $O_2$ gas.

[Table 1]

| $O_2$ | DT($\theta_1$) | DT($\theta_2$) | ST($\theta_3$) | ST($\theta_4$) |
|---|---|---|---|---|
| 30% | 14° | 13° | 28° | 26° |
| 40% | 10° | 9° | 18° | 18.3° |
| 50% | 6° | 6° | 7° | 7.5° |

Referring to Table 2, the threshold voltage deviation ($\Delta$Vth) of each transistor and the image retention due to the kickback voltage according to the taper angle deviation ($\Delta\theta$) of the respective transistors having different channel region areas will be described.

$|\Delta\theta_{(DT-ST)}|$ of the Table 2 represents the absolute value taper angle deviation of the driving transistor DT and the switching transistor ST in which the area of the channel regions are different from each other.

$|\Delta V_{th(DT-ST)}|$ denotes an absolute value threshold voltage deviation of the driving transistor DT and the switching transistor ST according to $|\Delta\theta_{(DT-ST)}|$. Image Retention refers to the duration of an image sticking according to $|\Delta\theta_{(DT-ST)}|$.

Referring to Table 2, as the taper angle deviation $|\Delta\theta_{(DT-ST)}|$ of transistors having different channel area areas is reduced, the threshold voltage deviation $|\Delta V_{th(DT-ST)}|$ and the kickback voltage is reduced. Therefore, when the electro-luminescence display device 100 displays an image, the image retention characteristic can be improved. Referring to Table 1, it is disclosed that as the $O_2$ gas flow rate ratio increases, the taper angle deviation $|\Delta\theta_{(DT-ST)}|$ decreases regardless of the area of the channel region of each transistor.

[Table 2]

| $|\Delta\theta_{(DT-ST)}|$ | $|\Delta V_{th(DT-ST)}|$ | Image Retention |
|---|---|---|
| 1° | 0.05 V | 0 Sec |
| 5° | 0.7 V | 20 Sec |
| 10° | 1.1 V | 50 Sec |
| 15° | 1.2 V | 60 Sec |

That is, referring to Table 2, preferably, a pixel P includes an electro-luminescence diode ELD, a driving transistor

DT configured to supply a current to the electro-luminescence diode, and a switching transistor ST configured to switch a signal supplied to the driving transistor, wherein the area of the channel region of the driving transistor DT and the area of the channel region of the switching transistor ST are different from each other and wherein the taper angle deviation of the channel regions of the driving transistor DT and the switching transistor ST $|\Delta\theta_{(DT-ST)}|$ is equal to or less than 10°.

More preferably, the taper angle deviation of the channel regions of the driving transistor DT and the switching transistor ST $|\Delta\theta_{(DT-ST)}|$ is equal to or less than 5°.

Even more preferably, the taper angle deviation of the channel regions of the driving transistor DT and the switching transistor ST $|\Delta\theta_{(DT-ST)}|$ is equal to or less than 1°.

Preferably, to achieve the taper angle deviation of the channel regions of the driving transistor DT and the switching transistor ST $|\Delta\theta_{(DT-ST)}|$ be equal to or less than 10°, the $O_2$ gas flow rate should be at least 30%.

More preferably, to achieve the taper angle deviation of the channel regions of the driving transistor DT and the switching transistor ST $|\Delta\theta_{(DT-ST)}|$ be equal to or less than 5°, the $O_2$ gas flow rate should be at least 40%.

Even more preferably, to achieve the taper angle deviation of the channel regions of the driving transistor DT and the switching transistor ST $|\Delta\theta_{(DT-ST)}|$ be equal to or less than 1°, the $O_2$ gas flow rate should be at least 50%.

For example, the O2 gas flow rate may be set from 50% to 60%.

That is, according to the dry etching process, the pixel P of the electro-luminescence display device 100 according to an embodiment of the present disclosure includes a plurality of transistors having different areas for the channel regions and the taper angle deviation of the channel regions can be minimized.

Also, according to the above-described configurations, there is an advantage that the threshold voltage deviations ($\Delta$Vth) of the transistors of the plurality of pixels P in the pixel area can be reduced. Further, according to the above-described configurations, there is an advantage that the image retention characteristic can be improved. Further, since the threshold voltage deviation is reduced, there is an advantage that the luminance uniformity of the pixel area can be improved.

The exemplary embodiments of the present disclosure can also be described as follows:

According to an aspect of the present disclosure, an electro-luminescence display device comprising: a pixel comprising: an electro-luminescence diode; a driving transistor configured to supply a current to the electro-luminescence diode; and a switching transistor configured to switch a signal supplied to the driving transistor, wherein a size of a channel area of the driving transistor may be different from a size of a channel area of the switching transistor, and wherein a taper angle deviation of the channel areas of the driving transistor and the switching transistor is equal to or less than 10°.

The taper angle deviation of the channel areas of the driving transistor and the switching transistors may be adjusted according to an $O_2$ gas flow rate during a dry etching process.

The taper angle deviation may be equal to or less than 5°.

The channel areas of the driving transistor and the switching transistor may be dry etched with the O2 gas flow rate equal to or more than 40%.

The taper angle deviation may be equal to or less than 1°.

The channel areas of the driving transistor and the switching transistor may be dry etched with the O2 gas flow rate equal to or more than 50%.

A taper angle of the channel areas of the driving transistor and a taper angle of the channel areas of the switch transistor may be respectively equal to or less than 20°.

The taper angle of the channel areas of the driving transistor and the taper angle of the channel areas of the switch transistor may be respectively equal to or less than 10°.

The taper angle deviation of the channel areas of the driving transistor and the switching transistor may be equal to or less than 5°.

The size of the channel area of the driving transistor may be larger than the size of the channel area of the switching transistor.

A semiconductor layer, configuring the driving transistor and the switching transistor, includes a low-temperature poly silicon layer.

According to another aspect of the present disclosure, a manufacturing method of an electro-luminescence display device comprising: providing a semiconductor layer on a substrate; patterning a photo-resist on the semiconductor layer by a photolithography process; and patterning a taper angle of channel areas of a driving transistor and a taper angle of channel areas of a switching transistor by a dry etching process with at least 30% of $O_2$ gas flow rate, wherein both the channel areas include the semiconductor layer, and the taper angles are equal to or less than a predetermined degree.

The semiconductor layer may be a low-temperature poly silicon layer which may be crystalized by a laser.

The predetermined degree may be equal to or less than 20°.

The predetermined degree may be equal to or less than 10° and the $O_2$ gas flow rate may be equal to or more than 50%.

A mixture gas used for the dry etching process includes the O2 gas and at least one gas among CF4, SF6, He, HCl and Cl2.

The $O_2$ gas flow rate is the portion of $O_2$ included the gas during dry etching.

Thus, according to the invention, by controlling the $O_2$ portion in the gas supplied during the dry etching process the taper angle of the channel areas can be controlled and/or adjusted.

It will be apparent to those skilled in the art that various modifications and variations can be made through the present disclosure without departing from the technical concepts and/or scope of the present disclosure. Accordingly, the technical concepts and/or scope of the present disclosure should not be limited to those described in the detailed description of the specification, but should be defined by the claims.

**Claims**

1.  An electro-luminescence display device comprising:

    a pixel (P) comprising:

      an electro-luminescence diode (ELD);
      a driving transistor (DT) configured to supply a current to the electro-luminescence diode (ELD); and
      a switching transistor (ST) configured to switch a signal supplied to the driving transistor (DT),

    wherein an area of a channel region of the driving transistor (DT) is different from an area of a channel region of the switching transistor (ST), and
    wherein the channel region of each of the driving transistor (DT) and the switching transistor (ST) includes a semi-conductor layer (ACT) having edges with a taper angle ($\theta$)), wherein a taper angle deviation ($|\Delta\theta_{(DT-ST)}|$) between the taper angle of the semiconductor layer of the driving transistor (DT) and the taper angle of the semiconductor layer of the switching transistor (ST) is equal to or less than 10°.

2.  The electro-luminescence display device of claim 1, wherein the taper angle deviation is adjusted by controlling an $O_2$ gas flow rate during a dry etching process.

3.  The electro-luminescence display device of claim 1 or 2, wherein the taper angle deviation is equal to or less than 5°.

4.  The electro-luminescence display device of claim 3, wherein the semiconductor layers of the driving transistor (DT) and the switching transistor (ST) are dry etched by controlling the $O_2$ gas flow rate equal to or more than 40%.

5.  The electro-luminescence display device of claim 3, wherein the taper angle deviation is equal to or less than 1°.

6.  The electro-luminescence display device of claim 5, wherein the semiconductor layers of the driving transistor (DT) and the switching transistor (ST) are dry etched by controlling the $O_2$ gas flow rate equal to or more than 50%.

7.  The electro-luminescence display device as claimed in any one of the preceding claims, wherein a taper angle of the semiconductor layer of the driving transistor (DT) and a taper angle of the semiconductor layer of the switching transistor (ST) are respectively equal to or less than 20°.

8.  The electro-luminescence display device as claimed in any one of the preceding claims, wherein the taper angle of the semiconductor layer of the driving transistor (DT) and the taper angle of the semiconductor layer of the switch transistor (ST) are respectively equal to or less than 10°.

9.  The electro-luminescence display device as claimed in any one of the preceding claims, wherein the taper angle deviation is equal to or less than 5°.

10. The electro-luminescence display device as claimed in any one of the preceding claims, wherein the area of the channel region of the driving transistor (DT) is larger than the area of the channel region of the switching transistor (ST).

11. The electro-luminescence display device as claimed in any one of the preceding claims, wherein the semiconductor layer (ACT), included respectively in the driving transistor (DT) and the switching transistor (ST), includes a low-temperature poly silicon layer.

12. A manufacturing method of an electro-luminescence display device comprising:

providing a semiconductor layer (ACT) on a substrate (SUB);
patterning a photo-resist on the semiconductor layer (ACT) by a photolithography process; and
patterning a taper angle ($\theta$) of channel region of a driving transistor (DT) and a taper angle ($\theta$) of channel region of a switching transistor (ST) by a dry etching process with at least 30% of $O_2$ gas flow rate, wherein both the channel regions include the semiconductor layer (ACT), and both the taper angles are defined by edges of the semiconductor layer (ACT), wherein the taper angles are equal to or less than a predetermined degree and a taper angle deviation ($|\Delta\theta_{(DT-ST)}|$) between the taper angle of the semiconductor layer of the driving transistor (DT) and the taper angle of the semiconductor layer of the switching transistor (ST) is equal to or less than 10°, and wherein an area of the channel region of the driving transistor (DT) is different from an area of the channel region of the switching transistor (ST).

13. The manufacturing method of claim 12, wherein the semiconductor layer (ACT) is a low-temperature poly silicon layer which is crystalized by a laser.

14. The manufacturing method of claim 12 or 13, wherein the predetermined degree of the taper angles is equal to or less than 20° and /or the predetermined degree of the taper angles is equal to or less than 10° and the $O_2$ gas flow rate is equal to or more than 50%.

15. The manufacturing method of claim 12, 13, or 14 wherein a mixture gas used for the dry etching process includes the $O_2$ gas and at least one gas among $CF_4$, $SF_6$, He, HCl and $Cl_2$.

**Patentansprüche**

1. Elektolumineszenzanzeigevorrichtung, die umfasst:

ein Pixel (P), das umfasst:

eine Elektrolumineszenzdiode (ELD);
einen Ansteuertransistor (DT), der konfiguriert ist, der Elektrolumineszenzdiode (ELD) einen Strom zuzuführen; und
einen Schalttransistor (ST), der konfiguriert ist, ein dem Ansteuertransistor (DT) zugeführtes Signal umzuschalten,

wobei ein Bereich eines Kanalgebiets des Ansteuertransistors (DT) von einem Bereich eines Kanalgebiets des Schalttransistors (ST) verschieden ist und
wobei das Kanalgebiet sowohl des Ansteuertransistors (DT) als auch des Schalttransistors (ST) eine Halbleiterschicht (ACT) enthält, die Kanten mit einem spitzen Winkel ($\theta$) aufweist, wobei eine Abweichung ($|\Delta\theta_{(DT-ST)}|$) des spitzen Winkels zwischen dem spitzen Winkel der Halbleiterschicht des Ansteuertransistors (DT) und dem spitzen Winkel der Halbleiterschicht des Schalttransistors (ST) gleich oder kleiner als 10° ist.

2. Elektolumineszenzanzeigevorrichtung nach Anspruch 1, wobei die Abweichung des spitzen Winkels durch Steuern einer $O_2$-Gasströmungsrate während eines Trockenätzprozesses angepasst wird.

3. Elektolumineszenzanzeigevorrichtung nach Anspruch 1 oder 2, wobei die Abweichung des spitzen Winkels gleich oder kleiner als 5° ist.

4. Elektolumineszenzanzeigevorrichtung nach Anspruch 3, wobei die Halbleiterschichten des Ansteuertransistors (DT) und des Schalttransistors (ST) durch Steuern der $O_2$-Gasströmungsrate gleich oder größer als 40 % trockengeätzt werden.

5. Elektolumineszenzanzeigevorrichtung nach Anspruch 3, wobei die Abweichung des spitzen Winkels gleich oder kleiner als 1° ist.

**6.** Elektolumineszenzanzeigevorrichtung nach Anspruch 5, wobei die Halbleiterschichten des Ansteuertransistors (DT) und des Schalttransistors (ST) durch Steuern der $O_2$-Gasströmungsrate gleich oder größer als 50 % trockengeätzt werden.

**7.** Elektolumineszenzanzeigevorrichtung nach einem der vorhergehenden Ansprüche, wobei ein spitzer Winkel der Halbleiterschicht des Ansteuertransistors (DT) und ein spitzer Winkel der Halbleiterschicht des Schalttransistors (ST) jeweils gleich oder kleiner als 20° sind.

**8.** Elektolumineszenzanzeigevorrichtung nach einem der vorhergehenden Ansprüche, wobei der spitze Winkel der Halbleiterschicht des Ansteuertransistors (DT) und der spitze Winkel der Halbleiterschicht des Schalttransistors (ST) jeweils gleich oder kleiner als 10° sind.

**9.** Elektolumineszenzanzeigevorrichtung nach einem der vorhergehenden Ansprüche, wobei die Abweichung des spitzen Winkels gleich oder kleiner als 5° ist.

**10.** Elektolumineszenzanzeigevorrichtung nach einem der vorhergehenden Ansprüche, wobei der Bereich des Kanalgebiets des Ansteuertransistors (DT) größer ist als der Bereich des Kanalgebiets des Schalttransistors (ST).

**11.** Elektolumineszenzanzeigevorrichtung nach einem der vorhergehenden Ansprüche, wobei die Halbleiterschicht (ACT), die in dem Ansteuertransistor (DT) bzw. dem Schalttransistor (ST) enthalten ist, eine Niedertemperaturpolysiliziumschicht enthält.

**12.** Herstellungsverfahren für eine Elektrolumineszenzanzeigevorrichtung, das Folgendes umfasst:

Bereitstellen einer Halbleiterschicht (ACT) auf einem Substrat (SUB);
Strukturieren eines Photoresist auf der Halbleiterschicht (ACT) durch einen Photolithographieprozess; und
Strukturen eines spitzen Winkels ($\theta$) des Kanalgebiets eines Ansteuertransistors (DT) und eines spitzen Winkels ($\theta$) des Kanalgebiets eines Schalttransistors (ST) durch einen Trockenätzprozess mit wenigstens 30 % $O_2$-Gasströmungsrate, wobei beide Kanalgebiete eine Halbleiterschicht (ACT) enthalten und beide spitze Winkel durch Kanten der Halbleiterschicht (ACT) definiert sind, wobei die spitzen Winkel gleich einem oder kleiner als ein vorbestimmter Grad sind und eine Abweichung des spitzen Winkels ($|\Delta\theta_{(DT-ST)}|$) zwischen dem spitzen Winkel der Halbleiterschicht des Ansteuertransistors (DT) und dem spitzen Winkel der Halbleiterschicht des Schalttransistors (ST) gleich oder kleiner als 10° ist und wobei ein Bereich des Kanalgebiets des Ansteuertransistors (DT) von einem Bereich des Kanalgebiets des Schalttransistors (ST) verschieden ist.

**13.** Herstellungsverfahren nach Anspruch 12, wobei die Halbleiterschicht (ACT) eine Tieftemperaturpolysiliziumschicht ist, die durch einen Laser kristallisiert ist.

**14.** Herstellungsverfahren nach Anspruch 12 oder 13, wobei der vorbestimmte Grad der spitzen Winkel gleich oder kleiner als 20° ist und/oder der vorbestimmte Grad der spitzen Winkel gleich oder kleiner als 10° ist und die $O_2$-Gasströmungsrate gleich oder größer als 50 % ist.

**15.** Herstellungsverfahren nach Anspruch 12, 13 oder 14, wobei ein Mischgas, das für den Trockenätzprozess verwendet ist, das $O_2$-Gas und wenigstens ein Gas aus $CF_4$, $SF_6$, He, HCl und $Cl_2$ enthält.

**Revendications**

**1.** Dispositif d'affichage électroluminescent comportant :

un pixel (P) comportant :

une diode électroluminescente (ELD) ;
un transistor d'attaque (DT) configuré pour fournir un courant à la diode électroluminescente (ELD) ; et
un transistor de commutation (ST) configuré pour commuter un signal fourni au transistor d'attaque (DT),

dans lequel une surface d'une zone de canal du transistor d'attaque (DT) est différente d'une surface d'une zone de canal du transistor de commutation (ST), et

dans lequel la zone de canal de chaque transistor parmi le transistor d'attaque (DT) et le transistor de commutation (ST) inclut une couche semi-conductrice (ACT) ayant des bords avec un angle d'inclinaison ($\theta$), dans lequel une déviation d'angle d'inclinaison ($|\Delta\theta_{(DT-ST)}|$) entre l'angle d'inclinaison de la couche semi-conductrice du transistor d'attaque (DT) et l'angle d'inclinaison de la couche semi-conductrice du transistor de commutation (ST) est égale ou inférieure à 10°.

2. Dispositif d'affichage électroluminescent selon la revendication 1, dans lequel la déviation d'angle d'inclinaison est réglée en commandant un débit de gaz $O_2$ pendant un processus de gravure sèche.

3. Dispositif d'affichage électroluminescent selon la revendication 1 ou 2, dans lequel la déviation d'angle d'inclinaison est égale ou inférieure à 5°.

4. Dispositif d'affichage électroluminescent selon la revendication 3, dans lequel les couches semi-conductrices du transistor d'attaque (DT) et du transistor de commutation (ST) sont gravées à sec en commandant le débit de gaz $O_2$ pour qu'il soit égal ou supérieur à 40 %.

5. Dispositif d'affichage électroluminescent selon la revendication 3, dans lequel la déviation d'angle d'inclinaison est égale ou inférieure à 1°.

6. Dispositif d'affichage électroluminescent selon la revendication 5, dans lequel les couches semi-conductrices du transistor d'attaque (DT) et du transistor de commutation (ST) sont gravées à sec en commandant le débit de gaz $O_2$ pour qu'il soit égal ou supérieur à 50%.

7. Dispositif d'affichage électroluminescent selon l'une quelconque des revendications précédentes, dans lequel un angle d'inclinaison de la couche semi-conductrice du transistor d'attaque (DT) et un angle d'inclinaison de la couche semi-conductrice du transistor de commutation (ST) sont respectivement égaux ou inférieurs à 20°.

8. Dispositif d'affichage électroluminescent selon l'une quelconque des revendications précédentes, dans lequel l'angle d'inclinaison de la couche semi-conductrice du transistor d'attaque (DT) et l'angle d'inclinaison de la couche semi-conductrice du transistor de commutation (ST) sont respectivement égaux ou inférieurs à 10°.

9. Dispositif d'affichage électroluminescent selon l'une quelconque des revendications précédentes, dans lequel la déviation d'angle d'inclinaison est égale ou inférieure à 5°.

10. Dispositif d'affichage électroluminescent selon l'une quelconque des revendications précédentes, dans lequel la surface de la zone de canal du transistor d'attaque (DT) est plus grande que la surface de la zone de canal du transistor de commutation (ST).

11. Dispositif d'affichage électroluminescent selon l'une quelconque des revendications précédentes, dans lequel la couche semi-conductrice (ACT), incluse respectivement dans le transistor d'attaque (DT) et le transistor de commutation (ST), inclut une couche de polysilicium à basse température.

12. Procédé de fabrication d'un dispositif d'affichage électroluminescent comportant les étapes consistant à :

fournir une couche semi-conductrice (ACT) sur un substrat (SUB) ;
former des motifs avec une résine photosensible sur la couche semi-conductrice (ACT) par un processus de photolithographie ; et
former des motifs avec un angle d'inclinaison ($\theta$) de zone de canal d'un transistor d'attaque (DT) et un angle d'inclinaison ($\theta$) de zone de canal d'un transistor de commutation (ST) par un processus de gravure sèche avec au moins 30 % de débit de gaz $O_2$, dans lequel les deux zones de canal de la couche semi-conductrice (ACT), et les deux angles d'inclinaison sont définis par des bords de la couche semi-conductrice (ACT), dans lequel les angles d'inclinaison sont égaux ou inférieurs à un degré prédéterminé et une déviation d'angle d'inclinaison ($|\Delta\theta_{(DT-ST)}|$) entre l'angle d'inclinaison de la couche semi-conductrice du transistor d'attaque (DT) et l'angle d'inclinaison de la couche semi-conductrice du transistor de commutation (ST) est égale ou inférieure à 10°, et dans lequel une surface de la zone de canal du transistor d'attaque (DT) est différente d'une surface de la zone de canal du transistor de commutation (ST).

13. Procédé de fabrication selon la revendication 12, dans lequel la couche semi-conductrice (ACT) est une couche de polysilicium à basse température qui est cristallisée par un laser.

14. Procédé de fabrication selon la revendication 12 ou 13, dans lequel le degré prédéterminé des angles d'inclinaison est égal ou inférieur à 20° et/ou le degré prédéterminé des angles d'inclinaison est égal ou inférieur à 10° et le débit de gaz $O_2$ est égal ou supérieur à 50 %.

15. Procédé de fabrication selon la revendication 12, 13 ou 14, dans lequel un gaz de mélange utilisé pour le processus de gravure sèche inclut le gaz $O_2$ et au moins un gaz parmi $CF_4$, $SF_6$, He, HCl et $Cl_2$.

FIG. 1

FIG. 2

FIG. 3

EP 3 343 624 B1

EP 3 343 624 B1

FIG. 4A

19

FIG. 4B

FIG. 4C

FIG. 5

## FIG. 6A

## FIG. 6B

# FIG. 7A

# FIG. 7B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2007085847 A1
- US 2014361290 A1

- US 2012282741 A1